# FASCICULE DE BREVET EUROPEEN

(11) **EP 2 229 040 B1**
(45) Date de publication et mention de la délivrance du brevet: **19.09.2012**
(21) Numéro de dépôt: 10001097.4
(22) Date de dépôt: 03.02.2010
(51) Int. Cl.: H05K 1/02, H05K 1/00, H01H 69/02, H01H 85/046, H01L 21/48

(54) **Procédé pour appliquer un produit èlectriquement conducteur, liquide lors de son application, sur un support afin de relier deux éléments électriquement conducteurs**
Verfahren zur Anwendung eines elektrisch leitenden Produkts, das bei seiner Anwendung flüssig ist, auf einer Halterung, um zwei elektrisch leitende Elemente miteinander zu verbinden
Method for applying an electrically conductive product, which is liquid at the time of application, on a support in order to connect two electrically conductive elements

(30) Priorité: 09.03.2009 FR 0901065
(43) Date de publication de la demande: 15.09.2010
(73) Titulaire: EUROCOPTER, 13725 Marignane Cédex (FR)
(72) Inventeur: Imbert, Nicolas, 13008 Marseille (FR); Chuc, Charles, 13008 Marseille (FR)
(74) Mandataire: GPI & Associés

(56) Documents cités:
- JP-A- 60 109 258
- US-A- 5 693 121
- US-A1- 2003 150 101

## Description

La présente invention concerne un procédé pour déposer un produit électriquement conducteur, liquide lors de son application, sur un support afin de relier deux éléments électriquement conducteurs par sérigraphie, par exemple la première extrémité libre d'une première piste électrique à la deuxième extrémité libre d'une deuxième piste électrique.

Plus particulièrement, le produit conducteur peut être un produit conducteur liquide lors de son application, de type encre conductrice, destiné à réaliser une connexion fusible entre deux pistes électriques d'un circuit électrique.

Il est à noter que l'on entend par encre conductrice un produit muni d'un substrat qui est liquide, même s'il est éventuellement pâteux, lors de son application et qui durcit après cette application. Par exemple, le substrat est muni d'un solvant apte à s'évaporer suite à l'application de l'encre conductrice, l'évaporation dudit solvant faisant passer l'encre conductrice d'un état liquide à un état solide.

De plus, ce substrat est chargé de particules électriquement conductrices, par exemple de la poudre d'argent, des fibres de carbone ou toute autre substance électriquement conductrice se présentant sous la forme de petites particules.

Le terme « encre » s'explique alors par la capacité du produit à être dans une phase liquide afin d'être appliqué sur une surface avant de se solidifier, le terme « conducteur » s'expliquant du fait de la présence, dans le substrat du produit, de particules électriquement conductrices.

Relier deux éléments électriquement conducteurs disposés sur un support isolant du circuit électrique à l'aide d'un produit électriquement conducteur liquide lors de son application est néanmoins extrêmement difficile.

En effet, afin que le circuit électrique soit fabriqué de manière industrielle, il convient d'utiliser un procédé parfaitement reproductible pour garantir que tous les circuits imprimés fabriqués ont des caractéristiques identiques.

Il est ainsi inconcevable d'appliquer manuellement le produit électriquement conducteur entre les deux éléments électriquement conducteurs à relier.

Un procédé pourrait consister à déposer ce produit électriquement conducteur par sérigraphie, la sérigraphie étant un procédé d'impression connu faisant appel à un masque. On se référera à la littérature pour obtenir plus de précision concernant cette technique.

Ainsi, durant une étape préliminaire, on peut envisager de déposer un masque muni d'une lumière au-dessus des premier et deuxième éléments électriquement conducteurs à relier.

Par suite, durant une étape de finition, on appliquerait par sérigraphie le produit électriquement conducteur. Ce produit électriquement conducteur se répandrait alors dans la lumière du masque afin de lier électriquement les premier et deuxième éléments électriquement conducteurs.

Bien que séduisant à première vue, ce procédé de sérigraphie classique ne semble pas applicable dans le cas présent, notamment si l'on désire lier la première extrémité d'une première piste électrique à la deuxième extrémité d'une deuxième piste électrique à l'aide d'un produit électriquement conducteur liquide lors de son application, tel que de l'encre conductrice munie de particules d'argent par exemple.

Il se trouve en effet que les pistes électriques fabriquées actuellement ont une première hauteur de l'ordre de 70 microns. Or, les machines de sérigraphie les plus performantes réalisent des couches d'au maximum 35 microns, en particulier en raison de l'épaisseur des masques eux-mêmes.

Efficace pour imprimer un produit sur une base parfaitement plane, la sérigraphie ne parait pas utilisable lorsque cette base présente un relief.

Par suite, le procédé n'est pas à même de garantir un dépôt uniforme, et donc reproductible, du produit électriquement conducteur.

En outre, le caractère liquide du produit électriquement conducteur induit une migration du produit lors de son application. Ainsi, ce produit peut éventuellement se trouver à proximité, voire même toucher indument, un élément conducteur distinct des premier et deuxième éléments conducteurs à relier.

Il est alors malheureusement possible de voir apparaître des arcs électriques destructeurs.

L'état de la technique inclut le document US2003/150101 relatif à un procédé pour réaliser un circuit imprimé.

Le document J60109258 a pour but d'augmenter la précision de la valeur de la résistance d'un élément électrique.

Enfin, le document US 59 63 121 a pour objet un procédé pour réaliser une connexion fusible entre deux pistes électriques.

La présente invention a dans ce contexte pour objet de proposer un procédé s'affranchissant des problèmes de migration et d'épaisseur mentionnés ci-dessus. Ainsi, l'invention vise à permettre la fabrication de manière industrielle et reproductible d'un circuit électrique muni d'un premier et d'un deuxième éléments électriquement conducteurs liés par une connexion comprenant un produit électriquement conducteur liquide lors de son application et solide postérieurement à ladite application.

Selon l'invention, un procédé pour lier électriquement un premier et un deuxième éléments électriquement conducteurs disposés sur un support, électriquement isolant, à l'aide d'une connexion comportant un produit électriquement conducteur étant liquide lors de son application et solide postérieurement à cette application, la connexion reliant une première extrémité du premier élément électriquement conducteur à une deuxième extrémité du deuxième élément électriquement conducteur, est remarquable en ce que :
- lors d'une phase de préparation, on appose par sérigraphie au moins une couche de vernis sur un ensemble comportant le support ainsi que les premier et deuxième éléments électriquement conducteurs afin de réaliser un espace de confinement de la connexion allant de la première extrémité à la deuxième extrémité,
- lors d'une phase de finition, on applique par sérigraphie le produit électriquement conducteur, par exemple de l'encre électriquement conductrice, pour le disposer dans l'espace de confinement.

Il est à noter que l'on entend par vernis tout produit, liquide avant séchage et plus ou moins à base de résine, usuellement utilisé pour ses caractéristiques isolantes et de protection des circuits électriques.

Par ailleurs, on comprend qu'à l'issue de la phase de finition, des couches additionnelles usuelles de produit peuvent être utilisées pour recouvrir intégralement le circuit électrique obtenu afin de le protéger des conditions environnementales, lesdites conditions étant particulièrement sévères dans le domaine aéronautique.

Par suite, lors de la phase de finition, le produit électriquement conducteur relie les première et deuxième extrémités tout en restant dans l'espace de confinement réalisé lors de la phase de préparation.

Ainsi, l'application par sérigraphie du produit électriquement conducteur est parfaitement maitrisée, l'espace de confinement étant en quelque sorte un sarcophage dans lequel est maintenu le produit électriquement conducteur. Il n'y a alors plus de risques de voir migrer indûment ce produit électriquement conducteur.

La sérigraphie d'un produit sur une base en relief, en l'occurrence l'ensemble comprenant le support et les premier et deuxième éléments électriquement conducteurs, devient alors possible.

Ce procédé peut aussi comporter une ou plusieurs des caractéristiques additionnelles qui suivent.

Notamment, durant une étape secondaire de préparation de la phase de préparation, on applique sur ledit ensemble un masque secondaire recouvrant uniquement les première et deuxième extrémités puis on appose au moins une couche secondaire de vernis par sérigraphie pour délimiter longitudinalement l'espace de confinement.

La couche secondaire de vernis recouvre alors le support ainsi que les premier et deuxième éléments électriquement conducteurs, à l'exception de leurs première et deuxième extrémités recouvertes par le masque secondaire durant cette étape secondaire de préparation.

De plus, la couche secondaire de vernis est aussi déposée entre les première et deuxième extrémités des premier et deuxième éléments électriquement conducteurs.

Ainsi, si ces premier et deuxième éléments électriquement conducteurs ont une épaisseur, à savoir une première hauteur, de 70 microns et si la couche secondaire de vernis a une épaisseur de 35 microns alors la couche secondaire de vernis réduit partiellement la troisième hauteur de l'espace séparant les premier et deuxième éléments électriquement conducteurs.

L'application d'un produit électriquement conducteur dans cet espace devient possible de manière reproductible.

A l'issue de cette étape secondaire de préparation, on enlève évidemment le masque secondaire.

A titre alternatif, on délimite longitudinalement et transversalement l'espace de confinement.

Ainsi, durant une étape primaire de préparation de la phase de préparation, on applique sur ledit ensemble un masque primaire puis on appose au moins une couche primaire de vernis par sérigraphie pour délimiter transversalement et longitudinalement l'espace de confinement, le masque primaire recouvrant uniquement une bande rectangulaire allant de la première extrémité à la deuxième extrémité.

Avantageusement, les premier et deuxième éléments électriquement conducteurs ayant une première largeur, cette bande a une deuxième largeur inférieure à la première largeur.

Selon un premier mode de réalisation non revendiqué, on met uniquement en oeuvre l'étape secondaire de préparation pour obtenir un espace de confinement délimité uniquement longitudinalement et d'une hauteur limitée.

Selon un deuxième mode de réalisation, on met uniquement en oeuvre l'étape primaire de préparation pour obtenir un espace de confinement délimité transversalement et longitudinalement. Néanmoins, la troisième hauteur de cet espace de confinement n'est pas limitée.

Il est à noter que les termes « primaire » et « secondaire » sont utilisés par commodité pour distinguer les étapes concernés.

Enfin, selon un troisième mode de réalisation préféré, on met en oeuvre l'étape primaire et l'étape secondaire de préparation pour obtenir un espace de confinement délimité longitudinalement et transversalement et ayant une troisième hauteur limitée, cet espace de confinement représentant une sorte de sarcophage.

On note que l'étape primaire de préparation succède avantageusement à l'étape secondaire de préparation. Toutefois, l'inverse est aussi envisageable.

Par ailleurs, durant une phase intermédiaire optionnelle réalisée entre les phases de préparation et de finition, on applique sur ledit ensemble recouvert partiellement d'au moins une couche de vernis, par une méthode chimique ou électrolytique usuelle, une simple pellicule d'accrochage sur les première et deuxième portions des première et deuxième extrémités libres des premier et deuxième éléments électriquement conducteurs devant être recouvertes par le produit électriquement conducteur durant la phase de finition.

La pellicule d'accrochage, par exemple à base d'un mélange de nickel et d'or, facilite alors l'accrochage du produit électriquement conducteur sur les première et deuxième extrémités.

Avantageusement, les premier et deuxième éléments conducteurs sont des première et deuxième pistes électriques.

Enfin, préalablement à la phase de préparation, on dispose éventuellement un plot, en cuivre par exemple, apte à diffuser la chaleur entre lesdits premier et deuxième éléments électriquement conducteurs.

Cette option est particulièrement intéressante lorsque le produit électriquement conducteur est destiné à faire office de connexion fusible. En effet, le plot diffusant la chaleur, on peut s'en servir pour définir précisément la valeur de l'intensité apte à faire rompre la connexion fusible.

La présente invention a aussi pour objet le procédé de fabrication du dispositif précité.

L'invention et ses avantages apparaîtront avec plus de détails dans le cadre de la description qui suit avec des exemples de réalisation donnés à titre illustratif en référence aux figures annexées qui représentent :
- la figure 1, une vue isométrique d'un circuit électrique muni d'un premier et d'un deuxième éléments électriquement conducteurs,
- les figures 2 à 4, des vues isométriques explicitant le premier mode de réalisation de l'invention,
- les figures 5 à 8, des vues isométriques explicitant le deuxième mode de réalisation de l'invention,
- les figures 9 à 13, des vues isométriques explicitant le troisième mode de réalisation de l'invention selon une première variante,
- la figure 14, une vue isométrique explicitant le troisième mode de réalisation de l'invention selon une seconde variante, et
- la figure 15, une vue isométrique montrant un plot selon l'invention.

Les éléments présents dans plusieurs figures distinctes sont affectés d'une seule et même référence.

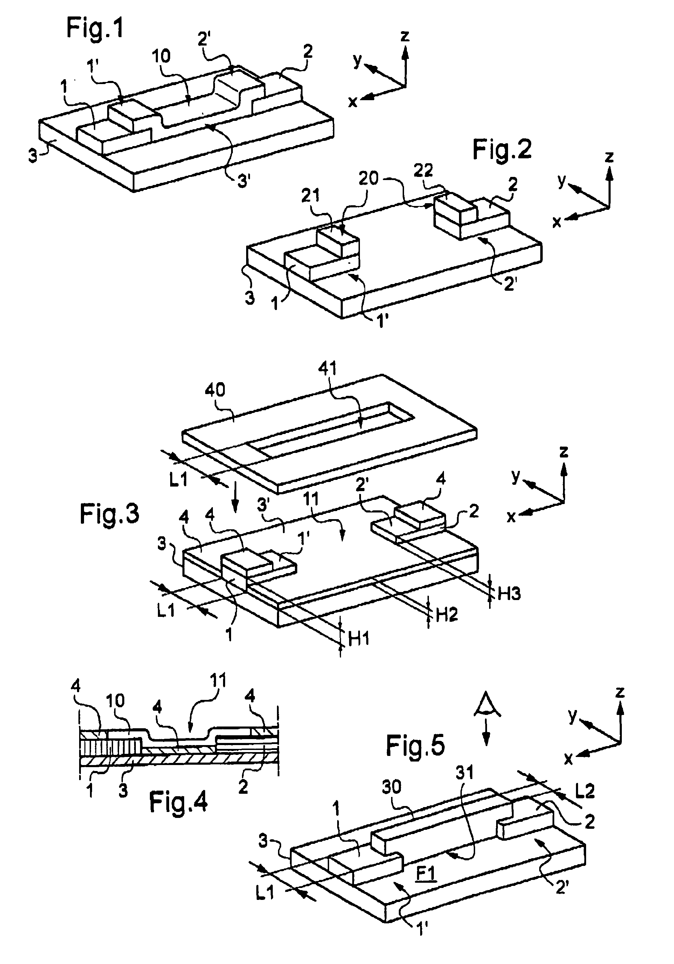

On note que trois directions X, Y et Z orthogonales les unes par rapport aux autres sont représentées sur les figures 1 et 2.

La direction X est dite longitudinale dans la mesure où les premier et deuxième éléments électriquement conducteurs s'étendent localement selon cette direction. Le terme « longueur » est relatif à une dimension longitudinale du dispositif selon cette direction longitudinale X.

Une autre direction Y est dite transversale. Le terme « largeur » est relatif à une dimension transverse du dispositif selon cette direction transversale.

Enfin, une troisième direction Z est dite d'élévation et correspond aux dimensions en hauteur des structures décrites. Les termes « épaisseur » et « hauteur » sont alors relatifs à une dimension en élévation selon cette direction d'élévation.

La figure 1 présente un circuit électrique muni d'un support 3 électrique isolant. On solidarise alors à ce support 3, tel qu'un support électriquement isolant de type usuel, un premier et un deuxième éléments électriquement conducteurs 1, 2, à savoir une première et une deuxième pistes électriques en cuivre par exemple, par une méthode usuelle.

Par ailleurs, ces premier et deuxième éléments électriquement conducteurs 1, 2 sont électriquement reliés par une connexion 10, une connexion fusible par exemple réalisée à l'aide d'un produit électriquement conducteur qui est liquide lors de son application et solide postérieurement à ladite application.

Un tel produit électriquement conducteur est avantageusement une encre conductrice. A partir d'une intensité prédéterminée, la connexion 10 fusible désolidarise les premier et deuxième éléments électriquement conducteurs 1, 2 pour les protéger.

Selon le procédé mis en oeuvre par l'invention, lors d'une phase de préparation, on appose par sérigraphie au moins une couche de vernis sur un ensemble comportant le support 3 ainsi que les premier et deuxième éléments électriquement conducteurs 1, 2 afin de réaliser un espace de confinement de la connexion 10 allant d'une première extrémité du premier élément électriquement conducteur 1 à une deuxième extrémité du deuxième élément électriquement conducteur 2. Il est à noter que la première extrémité est en vis-à-vis de la deuxième extrémité, ces première et deuxième extrémités 1, 2 étant séparées par un espace au moins partiellement vide, dénommé espace vide 3' par commodité.

Lors d'une phase de finition, on applique par sérigraphie le produit électriquement conducteur pour le disposer dans l'espace de confinement.

En référence à la figure 2, selon un premier mode de réalisation non revendiqué, durant une étape secondaire de préparation de la phase de préparation, on applique sur ledit ensemble un masque secondaire 20 recouvrant uniquement les première et deuxième extrémités 1', 2'. Plus précisément, un premier cache 21 du masque secondaire 20 est disposé sur la première extrémité 1' du premier élément électriquement conducteur 1, et un deuxième cache 22 du masque secondaire 20 est disposé sur la deuxième extrémité 2' du deuxième élément électriquement conducteur 2.

Lorsque le masque secondaire 20 est en place, on appose alors par sérigraphie, en implémentant une méthode connue dans le domaine de l'impression de marquages sur des circuits imprimés, au moins une couche secondaire de vernis par sérigraphie pour délimiter longitudinalement l'espace de confinement dans lequel sera déposé un produit électriquement conducteur.

En référence aux figures 3 et 4, on appose une couche secondaire de vernis 4 qui recouvre de fait le support 3 ainsi que les premier et deuxième éléments électriquement conducteurs 1, 2 à l'exception de leurs première et deuxième extrémités 1', 2'.

Ainsi, l'espace vide 3' séparant les première et deuxième extrémités 1', 2' est alors rempli complètement en surface par la couche secondaire de vernis mais partiellement selon la troisième direction Z en élévation.

Les premier et deuxième éléments électriquement conducteurs 1, 2 ayant une première hauteur H1 d'environ 70 microns et la couche secondaire de vernis 4 ayant une deuxième hauteur H2 d'environ 35 microns, ledit espace vide 3' n'a alors plus qu'une troisième hauteur H3 de 35 microns environ.

Il devient alors possible de remplir cet espace vide 3' de manière uniforme par sérigraphie à l'aide d'un produit électriquement conducteur.

En fonction, de la première hauteur des premier et deuxième éléments électriquement conducteurs 1, 2 et de la couche secondaire de vernis 4, il est possible de réitérer une ou plusieurs fois l'étape secondaire de préparation pour déposer non pas une, mais une pluralité de couches secondaires de vernis 4.

De plus, les premier et deuxième éléments électriquement conducteurs 1, 2 étant recouverts par une couche secondaire de vernis 4 , à l'exception de leurs première et deuxième extrémités 1', 2', la couche secondaire de vernis 4 permet de délimiter longitudinalement, à savoir selon la direction longitudinale X, un espace de confinement 11 destiné à accueillir le produit électriquement conducteur apte à relier les première et deuxième extrémités 1', 2'.

Suite à la phase de préparation, on met en oeuvre une phase de finition pour déposer le produit électriquement conducteur de la connexion 10.

Ainsi, on pose un masque de finition 40 sur le circuit électrique, ce masque de finition 40 comportant une lumière 41 en vis-à-vis de l'espace de confinement 11. On remarque que la lumière du masque de finition 40 à une largeur équivalente à la première largeur L1 des premier et deuxième éléments électriquement conducteurs 1, 2.

Ensuite, on répand par sérigraphie le produit électriquement conducteur pour former la connexion 10. Ce produit électriquement conducteur passe au travers de la lumière 41 du masque de finition 40 pour adhérer à la première extrémité 1', à la couche secondaire de vernis 4 et à la deuxième extrémité 2' au niveau de l'espace de confinement 11.

Il est à noter qu'il est envisageable de réaliser une phase intermédiaire postérieurement à la phase de préparation et antérieurement à la phase de finition.

Durant cette phase intermédiaire, on applique une pellicule d'un produit d'accrochage, du type dénommé « nickel-or » ou « étain-plomb » par l'homme du métier, sur les première et deuxième portions des première et deuxième extrémités 1', 2' devant être recouvertes par le produit électriquement conducteur. Cette application peut être mise en oeuvre par un procédé chimique ou électrolytique classique.

La figure 4 présente une coupe longitudinale du circuit obtenu par le premier mode de réalisation au niveau de l'espace de confinement.

On remarque notamment:
- que la couche secondaire de vernis 4 a bien rempli partiellement l'espace vide 3' séparant les première et deuxième éléments électriquement conducteurs 1, 2, et
- que la couche secondaire de vernis 4 présente sur les premier et deuxième éléments électriquement conducteurs 1, 2 délimite longitudinalement l'espace de confinement 11 et par suite, la connexion 10 déposée dans cet espace de confinement 11. En effet, la connexion 10 est longitudinalement confinée entre la couche secondaire de vernis 4 présente sur le premier élément électriquement conducteur 1 et la couche secondaire de vernis 4 présente sur le deuxième élément électriquement conducteur 2.

Ce premier mode de réalisation est particulièrement bien adapté lorsque d'une part la première hauteur des premier et deuxième éléments électriquement conducteurs 1, 2 est relativement importante en regard de la hauteur de la couche du produit électriquement conducteur et, d'autre part, lorsqu'il n'y a pas un autre élément électriquement conducteur à proximité.

En effet, l'espace de confinement 11 n'étant pas délimité transversalement, le produit électriquement conducteur risque de migrer latéralement lors de son application.

Les figures 5 à 8 présentent un deuxième mode de réalisation de l'invention.

En référence à la figure 5, selon le deuxième mode de réalisation, on ne met pas en oeuvre l'étape secondaire de préparation précédemment décrite mais uniquement une étape primaire de préparation.

Durant cette étape primaire de préparation de la phase de préparation, on applique sur le circuit électrique un masque primaire 30 de forme rectangulaire allant de la première extrémité 1' à la deuxième extrémité 2'. Plus précisément, le masque primaire 30 repose sur la première extrémité 1' du premier élément électriquement conducteur 1 et sur la deuxième extrémité 2' du deuxième élément électriquement conducteur 2.

Vu de dessus, à savoir selon l'axe Z, le masque primaire 30 recouvre une bande rectangulaire 31 allant de la première extrémité 1' à la deuxième extrémité 2', cette bande rectangulaire représentant la projection de l'espace de confinement 11 dans un plan X,Y contenant la face supérieure F1 du support 3 sur laquelle reposent les premier et deuxième éléments électriquement conducteurs 1, 2. Ainsi, le masque primaire 30 recouvre effectivement la bande rectangulaire 31 en reposant sur les première et deuxième extrémités 1', 2'.

Plus précisément, le masque primaire 30 s'étend longitudinalement de la première extrémité 1' à la deuxième extrémité libre 2' en restant en contact avec les éléments qu'il recouvre.

Ainsi, selon le mode de réalisation représenté, le masque primaire 30 a une forme de T afin d'être en contact avec d'une part les première et deuxième extrémités et, d'autre part, le support 3.

Avantageusement, les premier et deuxième éléments électriquement conducteurs 1, 2 ayant une première largeur L1, le masque primaire 30 a une deuxième largeur L2 inférieure à la première largeur L1.

De fait, il en va de même pour ladite bande rectangulaire 31 qui a aussi une deuxième largeur L2.

Lorsque le masque primaire 30 est en place, on appose alors par sérigraphie, en implémentant une méthode connue, au moins une couche primaire de vernis 5 pour délimiter longitudinalement et transversalement l'espace de confinement 11 dans lequel sera déposé un produit électriquement conducteur.

A l'issue de l'étape primaire de préparation, le masque primaire 30 est enlevé.

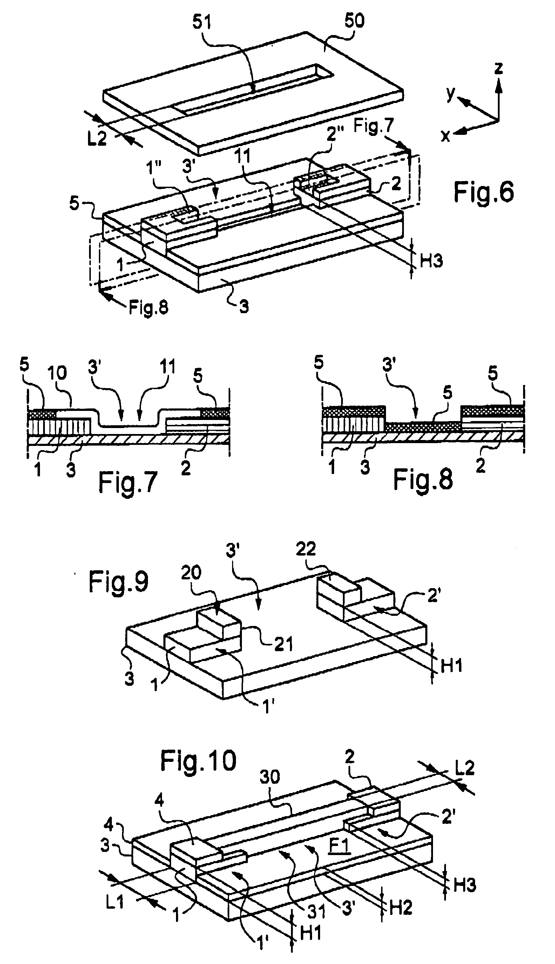

En référence à la figure 6, la couche primaire de vernis 5, déposée lors de l'étape primaire de préparation, recouvre de fait le support 3 ainsi que les premier et deuxième éléments électriquement conducteurs 1, 2 à l'exception des première et deuxième portions 1", 2" respectivement des première et deuxième extrémités 1', 2' masquées par le masque primaire 30.

De même, l'espace vide 3' séparant les première et deuxième extrémités est partiellement rempli par la couche primaire de vernis 5, à l'exception de la portion masquée par le masque primaire 30 se trouvant sous ce masque primaire lors de l'étape primaire de préparation.

En fonction du besoin, il est possible de réitérer une ou plusieurs fois l'étape primaire de préparation pour déposer non pas une, mais une pluralité de couches primaires de vernis 5.

De plus, les premier et deuxième éléments électriquement conducteurs 1, 2 étant recouverts par une couche primaire de vernis 5, à l'exception des première et deuxième portions 1", 2" de leurs première et deuxième extrémités 1', 2', la couche primaire de vernis 5 permet de délimiter longitudinalement et transversalement, à savoir selon la direction longitudinale X et la direction transversale Y, un espace de confinement 11 destiné à accueillir le produit électriquement conducteur apte à relier les première et deuxième extrémités 1', 2'.

Par contre, on note que, contrairement au premier mode de réalisation, la troisième hauteur H3 de l'espace vide 3' au niveau de l'espace de confinement 11, à savoir au niveau de la portion de l'espace vide masquée par le masque primaire 30, n'est pas réduite par la couche primaire de vernis 5.

Suite à la phase de préparation, on met en oeuvre une phase de finition pour déposer le produit électriquement conducteur de la connexion 10.

Ainsi, on pose par exemple un masque de finition 50 sur le circuit électrique, ce masque de finition 50 comportant une lumière 51 en vis-à-vis de l'espace de confinement 11. On remarque que la lumière du masque de finition 50 a une largeur égale à la largeur du masque primaire 30, utilisé durant l'étape primaire de préparation et enlevé à l'issue de cette étape primaire.

Ensuite, on répand par sérigraphie le produit électriquement conducteur qui passe au travers de la lumière 51 du masque de finition 50 pour adhérer à la première extrémité 1', au support 3 et à la deuxième extrémité 2', le produit électriquement conducteur étant contenu dans l'espace de confinement 11.

Il est à noter qu'il est envisageable de réaliser une phase intermédiaire postérieurement à la phase de préparation et antérieurement à la phase de finition.

Durant cette phase intermédiaire, on applique une pellicule d'un produit d'accrochage, du type dénommé « nickel-or » ou « étain-plomb » par l'homme du métier, sur les première et deuxième portions 1", 2" des première et deuxième extrémités 1', 2' devant être recouvertes par le produit électriquement conducteur. Cette application peut être mise en oeuvre par un procédé chimique ou électrolytique classique.

La figure 7 présente une coupe longitudinale du circuit obtenue par le deuxième mode de réalisation au niveau de l'espace de confinement.

On remarque notamment que :
- la couche primaire de vernis 5 ne remplit pas l'espace vide 3' séparant les premier et deuxième éléments électriquement conducteurs 1, 2 au niveau de l'espace de confinement 11, et
- la couche primaire de vernis 5 présente sur les premier et deuxième éléments électriquement conducteurs 1, 2 délimitent notamment longitudinalement l'espace de confinement 11 et par suite, la connexion 10 déposée dans cet espace de confinement 11.

La figure 8 présente une coupe longitudinale du circuit électrique obtenu par le deuxième mode de réalisation au bord de l'espace de confinement.

On remarque notamment que :
- la couche primaire de vernis 5 remplit partiellement l'espace vide 3' séparant les premier et deuxième éléments électriquement conducteurs 1, 2 sur les côtés de l'espace de confinement 11 ce qui permet de délimiter transversalement l'espace de confinement 11 entre les première et deuxième extrémités 1', 2', et
- la couche primaire de vernis 5 présente sur les premier et deuxième éléments électriquement conducteurs 1, 2 délimite notamment transversalement l'espace de confinement 11 et par suite, la connexion 10 déposée dans cet espace de confinement 11.

Ce deuxième mode de réalisation est particulièrement bien adapté lorsque d'une part la première hauteur des premier et deuxième éléments 1, 2 électriquement conducteurs est relativement faible en regard de la hauteur de la couche du produit électriquement conducteur et, d'autre part, lorsqu'il y a un autre élément électriquement conducteur à proximité tel qu'une troisième piste électrique.

En effet, l'espace de confinement 11 étant délimité transversalement, le produit électriquement conducteur ne risque pas de migrer latéralement lors de son application.

Les figures 9 à 13 présentent un troisième mode de réalisation préféré de l'invention.

Ce troisième mode de réalisation consiste en une combinaison des premier et deuxième modes de réalisation précédemment décrits.

Durant une étape secondaire de préparation de la phase de préparation représentée sur la figure 9, on applique sur le circuit électrique un masque secondaire 20 recouvrant uniquement les première et deuxième extrémités 1', 2'. Il est à noter que le masque secondaire 20 est représenté sur la figure 2.

Plus précisément, un premier cache 21 du masque secondaire 20 est disposé sur la première extrémité 1' du premier élément électriquement conducteur 1, et un deuxième cache 22 du masque secondaire 20 est disposé sur la deuxième extrémité 2 du deuxième élément électriquement conducteur 2.

Lorsque le masque secondaire 20 est en place, on appose alors par sérigraphie, en implémentant une méthode connue, au moins une couche secondaire de vernis 4 par sérigraphie.

Ainsi, on appose une couche secondaire de vernis 4 qui recouvre de fait le support 3 ainsi que les premier et deuxième éléments électriquement conducteurs 1, 2 à l'exception de leurs première et deuxième extrémités 1', 2'.

L'espace vide 3' séparant les première et deuxième extrémités 1', 2' est alors rempli par la couche secondaire de vernis 4.

Les premier et deuxième éléments électriquement conducteurs 1, 2 ayant une première hauteur H1 d'environ 70 microns et la couche secondaire de vernis 4 ayant une deuxième hauteur H2 d'environ 35 microns, ledit espace vide 3' n'a alors plus qu'une troisième hauteur H3 de 35 microns environ.

Il devient alors possible de le remplir de manière uniforme par sérigraphie à l'aide d'un produit électriquement conducteur.

En fonction, de la première hauteur des premier et deuxième éléments électriquement conducteurs 1, 2 et de la couche secondaire de vernis 4, il est possible de réitérer une ou plusieurs fois l'étape secondaire de préparation pour déposer non pas une mais une pluralité de couches secondaires de vernis 4.

Suite à l'étape secondaire de préparation de la phase de préparation, on enlève le masque secondaire 20 puis on met en oeuvre une étape primaire de préparation de la phase de préparation représentée par la figure 10.

Dés lors, on applique sur le circuit électrique un masque primaire 30 s'étendant longitudinalement de la première extrémité 1' à la deuxième extrémité 2'. Plus précisément, le masque primaire 30 repose sur la première extrémité 1' du premier élément électriquement conducteur 1, sur la deuxième extrémité 2' du deuxième élément électriquement conducteur 2, et sur le vernis disposé dans l'espace vide 3' entre les première et deuxième extrémités 1', 2'.

Si la hauteur de l'espace vide 3' a été entièrement comblée durant la première phase de préparation, par deux couches secondaires de vernis par exemple, le masque primaire 30 repose naturellement sur du vernis entre les première et deuxième extrémités 1', 2'.

Dans le cas contraire représenté sur la figure 10, le masque primaire 30 a une forme de T pour être en contact avec l'ensemble des éléments qu'il recouvre.

Vu de dessus, à savoir selon l'axe Z, le masque primaire 30 recouvre une bande rectangulaire 31 allant de la première extrémité 1' à la deuxième extrémité 2', cette bande rectangulaire représentant la projection de l'espace de confinement 11 dans un plan X,Y contenant la face supérieure F1 du support 3 sur laquelle repose les premier et deuxième éléments électriquement conducteurs 1, 2. Ainsi, le masque primaire 30 recouvre effectivement la bande rectangulaire 31 en reposant sur les première et deuxième extrémités 1', 2'.

Avantageusement, les premier et deuxième éléments électriquement conducteurs 1, 2 ayant une première largeur L1, le masque primaire 30 a une deuxième largeur L2 inférieure à la première largeur L1.

De fait, il en va de même pour ladite bande rectangulaire 31 qui a aussi une deuxième largeur L2.

Lorsque le masque primaire 30 est en place, on appose alors par sérigraphie, en implémentant une méthode connue par exemple, au moins une couche primaire de vernis 5.

A l'issue de l'étape primaire de préparation, on enlève le masque primaire 30.

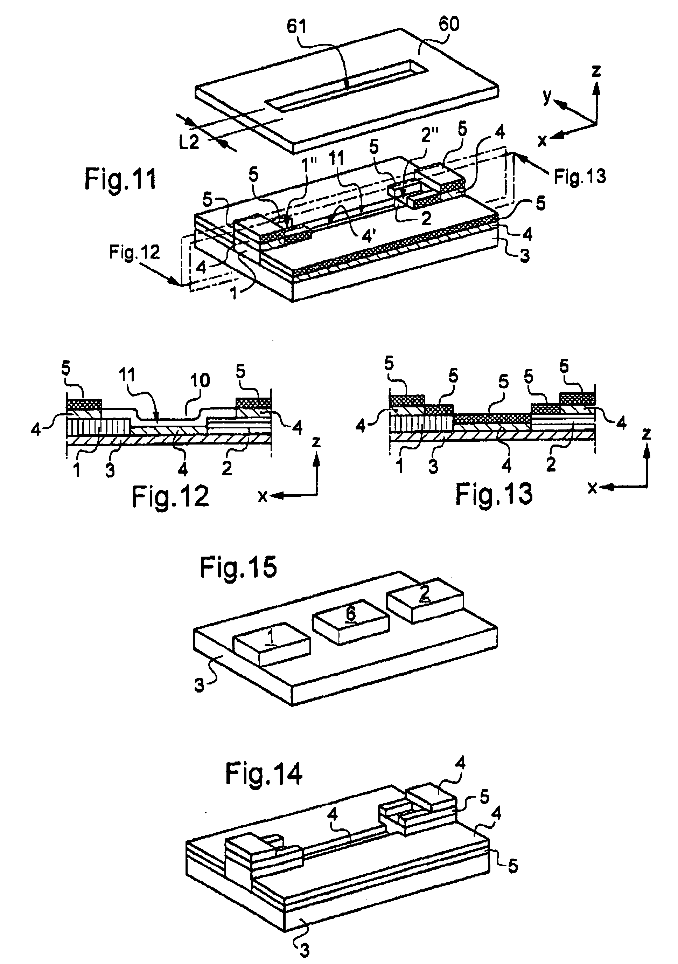

La figure 11 montre alors le résultat obtenu.

La couche primaire de vernis 5 recouvre de fait la couche secondaire de vernis 4, à l'exception de la portion 4' disposée en dessous du masque primaire 30 ainsi que les première et deuxième extrémités 1', 2' à l'exception de leurs portions 1", 2" protégées par le masque primaire 30.

En fonction du besoin, il est possible de réitérer une ou plusieurs fois l'étape primaire de préparation pour déposer non pas une mais une pluralité de couches primaires de vernis 5.

De plus, les premier et deuxième éléments électriquement conducteurs 1, 2 étant recouverts par une couche primaire et une couche secondaire de vernis 4, 5, à l'exception des portions protégées 1", 2" des première et deuxième extrémités 1', 2', la couche primaire et la couche secondaire de vernis 4, 5 permettent de délimiter longitudinalement et transversalement, à savoir selon la direction longitudinale X et la direction transversale Y, un espace de confinement 11 destiné à accueillir le produit électriquement conducteur apte à relier les première et deuxième extrémités 1', 2'.

Par contre, on note que, contrairement au deuxième mode de réalisation, la troisième hauteur H3 de l'espace vide 3' au niveau de l'espace de confinement 11 est réduite par la couche secondaire de vernis 4.

Le troisième mode de réalisation préféré présente donc les avantages des premier et deuxième modes de réalisation.

Suite à la phase de préparation, on met en oeuvre une phase de finition pour déposer le produit électriquement conducteur de la connexion 10.

Ainsi, on pose par exemple un masque de finition 60 sur le circuit électrique, ce masque de finition 60 comportant une lumière 61 en vis-à-vis de l'espace de confinement 11. On remarque que la lumière du masque de finition 60 à une largeur égale à la largeur du masque primaire 30.

Ensuite, on répand par sérigraphie le produit électriquement conducteur qui passe au travers de la lumière 61 du masque de finition 60 pour adhérer à la première extrémité 1', à la couche secondaire de vernis 4 et à la deuxième extrémité 2', tout en étant contenu dans l'espace de confinement 11.

Il est à noter qu'il est envisageable de réaliser une phase intermédiaire postérieurement à la phase de préparation et antérieurement à la phase de finition.

Durant cette phase intermédiaire, on applique une pellicule d'un produit d'accrochage, du type dénommé « nickel-or » ou « étain-plomb » par l'homme du métier, sur les première et deuxième portions 1", 2" des première et deuxième extrémités 1', 2' devant être recouvertes par le produit électriquement conducteur. Cette application peut être mise en oeuvre par un procédé chimique ou électrolytique classique.

La figure 12 présente une coupe longitudinale du circuit obtenu par le troisième mode de réalisation au niveau de l'espace de confinement.

On remarque notamment que :
- contrairement à la couche primaire de vernis 5, la couche secondaire de vernis 4 remplit l'espace vide séparant les première et deuxième éléments électriquement conducteurs 1, 2 dans l'espace de confinement 11, et
- les couches primaire et secondaire de vernis 4, 5 présentes sur les première et deuxième éléments électriquement conducteurs 1, 2 délimitent notamment longitudinalement l'espace de confinement 11 et par suite, la connexion 10 déposée dans cet espace de confinement 11.

La figure 13 présente une coupe longitudinale du circuit obtenu par le troisième mode de réalisation au bord de l'espace de confinement.

On remarque notamment que :
- la couche primaire de vernis 5 remplit partiellement l'espace vide séparant les première et deuxième éléments électriquement conducteurs 1, 2 sur les côtés de l'espace de confinement 11 ce qui permet de délimiter transversalement l'espace de confinement 11 entre les première et deuxième extrémités 1', 2', et
- la couche primaire de vernis 5 présente sur les premier et deuxième éléments électriquement conducteurs 1, 2 délimitent notamment transversalement l'espace de confinement 11 et par suite, la connexion 10 déposée dans cet espace de confinement 11.

Selon une variante du troisième mode de réalisation représentée sur la figure 14, on réalise l'étape primaire de préparation avant l'étape secondaire de préparation, contrairement à la variante de ce troisième mode de réalisation explicitée par les figures 9 à 13.

L'agencement des couches de vernis les unes par rapport aux autres diffère légèrement de cette variante du troisième mode de réalisation explicitée par les figures 9 à 13. Toutefois, l'espace de confinement 11 demeure identique.

Enfin, en référence à la figure 15, préalablement à la phase de préparation, on solidarise avantageusement un plot 6, en cuivre par exemple, sur le support 3 entre les première et deuxième extrémités 1', 2' afin de réduire l'échauffement de la connexion 10.

## Revendications

1. Procédé pour lier électriquement un premier et un deuxième éléments électriquement conducteurs (1, 2) disposés sur un support (3) à l'aide d'une connexion (10) comportant un produit électriquement conducteur étant liquide lors de son application et solide postérieurement à ladite application, ladite connexion (10) reliant un première extrémité (1') dudit premier élément électriquement conducteur (1) à une deuxième extrémité (2') dudit deuxième élément électriquement conducteur (2),
au cours duquel :
- lors d'une phase de préparation, on applique sur un ensemble comportant ledit support (3) ainsi que lesdits premier et deuxième éléments électriquement conducteurs (1, 2) afin de réaliser un espace de confinement (11) de ladite connexion (10) allant de ladite première extrémité (1') à ladite deuxième extrémité (2'), un masque primaire (30) puis on appose au moins une couche primaire de vernis (5) par sérigraphie pour délimiter transversalement et longitudinalement ledit espace de confinement (11), ledit masque primaire (30) recouvrant uniquement une bande (31) rectangulaire allant de ladite première extrémité (1') à ladite deuxième extrémité (2'),
- lors d'une phase de finition, on applique par sérigraphie ledit produit électriquement conducteur pour le disposer dans ledit espace de confinement (11).

2. Procédé selon la revendication 1,
**caractérisé en ce que** durant une étape secondaire de préparation de la phase de préparation, on applique sur ledit ensemble un masque secondaire (20) recouvrant uniquement lesdites première et deuxième extrémités (1', 2') puis on appose au moins une couche secondaire de vernis (4) par sérigraphie pour délimiter longitudinalement ledit espace de confinement (11).

3. Procédé selon l'une quelconque des revendications précédentes,
**caractérisé en ce que**, les premier et deuxième éléments électriquement conducteurs (1, 2) ayant une première largeur (L1), ladite bande (31) a une deuxième largeur (L2) inférieure à ladite première largeur (L1).

4. Procédé selon l'une quelconque des revendications précédentes,
**caractérisé en ce que** durant une phase intermédiaire réalisée entre les phases de préparation et de finition, on applique sur ledit ensemble recouvert partiellement d'au moins une couche de vernis une pellicule d'un produit d'accrochage sur les première et deuxième portions (1", 2") des première et deuxième extrémités (1', 2') devant être recouvertes par le produit électriquement conducteur durant la phase de finition.

5. Procédé selon l'une quelconque des revendications précédentes,
**caractérisé en ce que** ledit produit conducteur est une encre électriquement conductrice.

6. Procédé selon l'une quelconque des revendications précédentes,
**caractérisé en ce que** les premier et deuxième éléments conducteurs (1, 2) sont des première et deuxième pistes électriques.

7. Procédé selon l'une quelconque des revendications précédentes,
**caractérisé en ce que**, préalablement à la phase de préparation, on dispose un plot (6), apte à diffuser la chaleur, entre lesdits premier et deuxième éléments conducteurs (1, 2).

## Claims

1. Method for electrically connecting first and second electrically conductive elements (1, 2) arranged on a support (3) with the aid of a connection (10) comprising an electrically conductive product being liquid during its application and solid after said application, said connection (10) connecting a first end (1') of said first electrically conductive element (1) to a second end (2') of said second electrically conductive element (2),
in which method:
- during a preparation phase, a primary mask (30) is applied to an assembly comprising said support (3) and said first and second electrically conductive elements (1, 2) in order to produce a confinement space (11) of said connection (10) running from said first end (1') to said second end (2'), and then at least one primary layer of varnish (5) is deposited by screen printing in order to delimit said confinement space (11) transversely and longitudinally, said primary mask (30) covering only a rectangular strip (31) running from said first end (1') to said second end (2'),
- during a finishing phase, said electrically conductive product is applied by screen printing in order to arrange it in said confinement space (11).

2. Method according to Claim 1,
**characterised in that**, during a secondary preparation step of the preparation phase, a secondary mask (20) covering only said first and second ends (1', 2') is applied to said assembly, and then at least one secondary layer of varnish (4) is deposited by screen printing in order to delimit said confinement space (11) longitudinally.

3. Method according to any one of the preceding claims,
**characterised in that** the first and second electrically conductive elements (1, 2) have a first width (L1), and said strip (31) has a second width (L2) less than said first width (L1).

4. Method according to any one of the preceding claims,
**characterised in that**, during an intermediate phase performed between the preparation and finishing phases, there is applied to said assembly covered partially with at least one layer of varnish a film of a bonding product to the first and second portions (1", 2") of the first and second ends (1', 2') which are to be covered by the electrically conductive product during the finishing phase.

5. Method according to any one of the preceding claims,
**characterised in that** said conductive product is an electrically conductive ink.

6. Method according to any one of the preceding claims,
**characterised in that** the first and second conductive elements (1, 2) are first and second electric tracks.

7. Method according to any one of the preceding claims,
**characterised in that**, before the preparation phase, a block (6), suitable for diffusing heat, is arranged between said first and second conductive elements (1, 2).

## Patentansprüche

1. Verfahren zum elektrischen Verbinden eines ersten und eines zweiten elektrisch leitenden Elements (1, 2), die auf einem Träger (3) mit Hilfe einer Verbindung (10) angeordnet sind, die ein elektrisch leitendes Material aufweist, welches während seiner Anwendung flüssig und nach dieser Anwendung fest ist, wobei die Verbindung (10) ein erstes Ende (1') des ersten elektrisch leitenden Elements (1) mit einem zweiten Ende (2') des zweiten elektrisch leitenden Elements (2) verbindet, bei dem:
- man während einer Vorbereitungsphase auf einer Anordnung, die den Träger (3) sowie das erste und das zweite elektrisch leitende Element (1, 2) aufweist, eine erste Maske (30) aufbringt, um einen Eingrenzungsraum (11) der Verbindung (10) zu bilden, welcher von dem ersten Ende (1') bis zum zweiten Ende (2') reicht, und man anschließend mindestens eine erste Lackschicht (5) durch Siebdruck in Quer- und Längsrichtung den Eingrenzungsraum eingrenzt, wobei die erste Maske (30) ausschließlich ein rechtwinkliges Band (31) abdeckt, welches von dem ersten Ende (1') bis zum zweiten Ende (2') reicht,
- man während einer Abschlussphase durch Siebdruck das elektrisch leitende Material aufbringt, um es in dem Eingrenzungsraum (11) anzuordnen.

2. Verfahren nach Anspruch 1,
**dadurch gekennzeichnet, dass** während eines zweiten Vorbereitungsschritts der Vorbereitungsphase auf der Anordnung eine zweite Maske (20) aufgebracht wird, die ausschließlich die ersten und zweiten Enden (1', 2') abdeckt, und anschließend mindestens eine zweite Lackschicht (4) durch Siebdruck aufgebracht wird, um den Eingrenzungsraum (11) in Längsrichtung zu begrenzen.

3. Verfahren nach einem der vorstehenden Ansprüche,
**dadurch gekennzeichnet, dass** das erste und das zweite elektrisch leitende Element (1, 2) eine erste Breite (L1) aufweisen, wobei das Band (31) eine zweite Breite (L2) aufweist, die kleiner ist als die erste Breite (L1).

4. Verfahren nach einem der vorstehenden Ansprüche,
**dadurch gekennzeichnet, dass** während einer Zwischenphase zwischen der Vorbereitungsphase und der Fertigstellungsphase auf der Anordnung, die teilweise von mindestens einer Lackschicht bedeckt ist, eine dünne Schicht eines Haftungsvermittlungsmaterials auf den ersten und zweiten Bereichen (1", 2") der ersten und zweiten Enden (1', 2') aufgebracht wird, bevor diese mit dem elektrisch leitenden Material während der Fertigstellungsphase bedeckt werden.

5. Verfahren nach einem der vorstehenden Ansprüche,
**dadurch gekennzeichnet, dass** das elektrisch leitende Material eine elektrisch leitende Tinte ist.

6. Verfahren nach einem der vorstehenden Ansprüche,
**dadurch gekennzeichnet, dass** die ersten und zweiten elektrisch leitenden Elemente (1, 2) erste und zweite elektrische Strompfade sind.

7. Verfahren nach einem der vorstehenden Ansprüche,
**dadurch gekennzeichnet, dass** vor der Vorbereitungsphase zwischen dem ersten und dem zweiten elektrisch leitenden Element (1, 2) ein Lötkontakt aufgebracht wird, der Wärme abgeben kann.
